# EUROPÄISCHE PATENTSCHRIFT

(11) **EP 0 922 122 B1**
(45) Veröffentlichungstag und Bekanntmachung des Hinweises auf die Patenterteilung: **12.03.2003**
(21) Anmeldenummer: 97940121.3
(22) Anmeldetag: 23.08.1997
(51) Int. Cl.: C23C 16/52

(54) **PLASMA-CVD-ANLAGE MIT EINEM ARRAY VON MIKROWELLEN-PLASMAELEKTRODEN UND PLASMA-CVD-VERFAHREN**
PLASMA CVD SYSTEM WITH AN ARRAY OF MICROWAVE PLASMA ELECTRODES AND PLASMA CVD PROCESS
SYSTEME DE DEPOT CHIMIQUE EN PHASE VAPEUR PAR PLASMA AVEC UNE RANGEE D'ELECTRODES A PLASMA ACTIVEES PAR MICRO-ONDES

(30) Priorität: 29.08.1996 DE 19634795
(43) Veröffentlichungstag der Anmeldung: 16.06.1999
(73) Patentinhaber: Schott Glas, 55122 Mainz (DE); CARL-ZEISS-STIFTUNG trading as Schott Glas, 55122 Mainz (DE)
(72) Erfinder: WALTHER, Marten, D-55270 Engelstadt (DE); MÖHL, Wolfgang, D-67550 Worms (DE); DANIELZIK, Burkhard, D-55218 Ingelheim (DE); KUHR, Markus, D-55291 Saulheim (DE); HOCHHAUS, Roland, D-55216 Mainz (DE); BAUCH, Hartmut, D-62176 Weilrod (DE); HEMING, Martin, D-55442 Stromberg (DE); KÜPPER, Thomas, D-37581 Bad Gandersheim (DE); BEWIG, Lars, D-37581 Bad Gandersheim (DE)
(74) Vertreter: Müller-Rissmann, Werner Albrecht, Dr.
(86) Internationale Anmeldenummer: EP9704605
(87) Internationale Veröffentlichungsnummer: WO98008998

(56) Entgegenhaltungen:
- DE-A- 3 830 249

## Beschreibung

Die Erfindung betrifft eine plasmagestützte Anlage zur chemischen Gasphasen-Abscheidung mit einer rasterförmigen Anordnung von Mikrowellen-Plasmaelektroden und einer Steuerschaltung, sowie ein entsprechendes Beschichtungsverfahren.

Derartiges ist aus der US 5017404 A (DE 38 30 249 C2) bekannt. Dort ist vorgesehen, daß die einzelnen Plasmaelektroden so angeordnet sind, daß sich die erzeugten Plasmasäulen überlagern. Die einzelnen Plasmaelektroden sind unabhängig voneinander über die zugeführte elektronische Leistung schaltund steuerbar, und zwar wird dies benutzt, um Randeffekte auszugleichen oder einen gezielten Verlauf der Beschichtungseigenschaften zu erzeugen. Ausdrücklich wird davon ausgegangen, daß es nicht zu störenden Interferenzeffekten bei den Hochfrequenzfeldern kommt.

Die Anwendung im Rahmen der Plasmaimpuls-CVD-Technik ist beschrieben, wie auch Beispiele für Mikrowellenantennen usw. angegeben sind. Die Beispiele betreffen zweidimensionale Arrays.

Die genannte US 5017404 A wird ausdrücklich als Teil der Offenbarung dieser Anmeldung angegeben, aus der apparative Ausbildungen von Systemen zu entnehmen sind, welche bei geeigneter Ansteuerung der Plasmaelektroden zur Ausführung der Erfindung geeignet sind.

Bei hohen Anforderungen an die Homogenität großflächiger Schichten hat sich gezeigt, daß bei optimaler Gestaltung der Überlappung der Plasmasäulen doch - im Gegensatz zur genannten Schrift - Interferenz benachbarter Mikrowellenfelder störend in Erscheinung tritt.

Die EP 0 420 117 A beschreibt die Störung durch Interferenz bei Plasma-CVD mit Anregung durch ein Mikrowellen-Array und hält einen stabilen Betrieb ohne deren Ausschaltung für unmöglich. Es wird vorgeschlagen, verschiedene Polarisationen, also Richtungen des elektrischen Feldvektors, bei benachbarten Mikrowellenquellen vorzusehen.

Hier ist es aber offensichtlich erschwert, homogene Anregungsverhältnisse in den einzelnen Modulen zu erreichen, da die gekreuzten Kastenhohlleiter, welche in den Beispielen gezeigt sind, das aufgrund der asymmetrischen Hohlleitergeometrie nicht zulassen.

Eine andere Art der Interferenzvermeidung wäre die Frequenzverschiebung benachbarter Plasmaelektroden. Kommerzielle Mikrowellengeneratoren haben jedoch deutliche Frequenzschwankungen, sowie hohe Bandbreiten, speziell im Impulsbetrieb, so daß relativ große Frequenzunterschiede erforderlich wären. Dann können aber unterschiedliche plasmachemische Verhaltensweisen nicht mehr ausgeschlossen werden. Zudem sind nicht ohne weiteres Mikrowellengeneratoren beliebiger Frequenz zu beschaffen, da nur für zugelassene Industriefrequenzen ein wirtschaftliches Arbeiten möglich ist.

Übliche Plasma-CVD-Verfahren sind dadurch gekennzeichnet, daß während der gesamten Beschichtungsdauer das Reaktionsgas über das Substrat strömt und gleichzeitig plasmaerzeugende Energie in das Reaktionsvolumen eingebracht wird, so daß Reaktionsgas und Abgas einer bereits erfolgten (i.a. schichtbildenden) Reaktion entweder in einer unübersichtlichen Art vermischt oder an unterschiedlichen Orten des Substrats mit unterschiedlichen Anteilen vertreten sind. Dadurch werden die Schnelligkeit einer Entwicklung, Eigenschaften der Beschichtung (speziell Dichte, Haftfestigkeit und Stabilität) sowie die Ausbeute an Reaktionsgas limitiert.

Derartige Limitierungen werden durch die Anwendung des Flasma-Impuls-CVD-Verfahren (PICVD-Verfahren) überwunden.

Bei diesem Verfahren wird die plasmaerzeugende Energie gepulst eingebracht, während das Reaktionsgas kontinuierlich in den Reaktionsraum strömt. Typisch für das PICVD-Verfahren ist die Anpassung der Impulspause an die Zeit, die erforderlich ist, das Gasvolumen über dem Substrat, welches in die (schichtbildende) Reaktion einbezogen wird, vollständig durch frisches Reaktionsgas auszutauschen. Diese Zeit ist von mehreren Parametern, wie z.B. Substratgröße und Form, Massenfluß und Temperatur des Reaktionsgases, Druck im Reaktor und Art der Gaseinströmung (z.B. Düsenform) abhängig.

Das Verfahren arbeitet ähnlich wie ein Zweitaktmotor, dem schichtbildenden Plasmaimpuls folgt die Impulspause, in der das verbrauchte Gas durch Frischgas ersetzt wird.

Ein weiterer Vorteil dieses Verfahrens ist die geringe Temperaturbelastung des Substrats, da die Beaufschlagung mit Energie nur während der Impulsdauer erfolgt und sich das Substrat in der Impulspause abkühlt. Dadurch wird es umgekehrt möglich, während des Impulses vergleichsweise hohe Energien anzuwenden, und so z.B. Schichten mit Eigenschaften abzuscheiden, die sonst nur das Massivmaterial aufweist.

Typischerweise liegen die Werte für die Dauer der Impulse zwischen 0.1 und 10 ms und für die Dauer der Impulspausen zwischen 10 und 100 ms.

Es ist günstig, die Energie mit Mikrowellen einzustrahlen, weil dann Plasmen bei Gasdrücken im mbar-Bereich erzeugt werden können. Solche Gasdrücke sind mit vergleichsweise geringem Aufwand herstellbar. Das PICVD-Verfahren läßt sich beispielsweise vorteilhaft anwenden zur Innenbeschichtung von dielektrischen Rohren, aus denen zum Beispiel Vorformen für Nachrichtenfasern hergestellt werden (EP 0 036 191, DE 38 30 622, DE 40 34 211), zur Aufbringung von IR-durchlässigen dielektrischen Spiegeln auf kalottenförmige Glassubstrate (DE-40 08 405, DE-43 34 572) oder zur Abscheidung von ebenen Dünnschichtwellenleitern auf Glas oder Kunststoff (DE-41 37 606, DE-42 28 853).

DE-A-3 830 249 offenbart eine plasmagestützte Anlage und ein Verfahren zur chemischen Gasphasen-Abscheidung mit einer Anordnung von mehreren so dicht nebeneinander angeordneten Plasmaelektroden, daß die von ihnen erzeugten Plasmasäulen mit einander überlappen, ohne daß es dabei jedoch zu einer störenden, gegenseitigen Beeinflussung kommt. Die Plasmaelektroden können daher unabhängig voneinander geschaltet und gesteuert werden.

Aufgabe der Erfindung ist die Bereitstellung einer gattungsgemäßen Plasma-CVD-Anlage und eines entsprechenden Verfahrens, wobei beliebige Skalierbarkeit der Abmessungen der Beschichtungseinheit und hervorrragende Homogenität der erzeugten Schichten mit wirtschaftlicher Konstruktion erzielt werden.

Die Lösung gelingt mit einer Anlage nach Anspruch 1 und entsprechend mit einem Verfahren nach Anspruch 5.

Die zeitliche Entkopplung der Mikrowellen-Anregung benachbarter Plasmaelektroden zeigt sich als weitere Möglichkeit zur Vermeidung von Interferenzen. Die Mikrowellenleistung kann wesentlich schneller getaktet werden, als der Pulsdauer eines den Gasvorrat erschöpfenden Pulses des Plasmaimpuls-CVD-Verfahrens (PICVD) entspricht. Damit können benachbarte Plasmaelektroden zeitlich versetzt getaktet werden, ohne daß das Plasma und das Abscheideverhalten des PICVD-Verfahrens dadurch störend beeinflußt werden.

Gemäß der Erfindung kann mit einem modularen System die simultan beschichtete Fläche beliebig skaliert werden. Die mit wenigen Modulen gewonnenen Kenntnisse können auf ein Array mit beliebig vielen Modulen übertragen werden.

Weitere vorteilhafte Ausgestaltungen sind Gegenstand der Unteransprüche 2 bis 4 bzw. 6 bis 11. Einige zehn bis einige Hundert Pulse, jeweils zeitlich versetzt für benachbarte Plasmaelektroden, können nach Anspruch 7 einen Gesamtimpuls des PICVD-Verfahrens bilden.

Ansprüche 2 und 8 geben die Kombination mit einer Radiofrequenz-Anregung (RF) an. Dies erlaubt in Verbindung mit der erfindungsgemäßen Mikrowellenanregung durch geeignete Steuerung der Feldverteilung mittels geeigneter Dimensionierung von Abstand und Ausdehnung der RF-Elektroden eine weitere Uniformisierung der Schichten. Die RF-Anregung kann auch gepulst werden, entweder synchron zur Mikrowelle (schon zur Energieeinsparung) oder auch in gezielt anderem Zeitverlauf.

An sich ist die Kombination von Mikrowellen- und Radiofrequenz-Anregung aus Moisan M., Wertheimer M.R., Surface and Coatings Technology 59 (1993), pp. 1-13 bekannt. Ziel dabei war die Veränderung der Schichtqualität durch Ionenbeschuß. Hier dagegen wird die einfache Formbarkeit der Feldlinien der RF-Anregung genutzt, um die Homogenität der Schicht zu verbessern.

Weiterhin kann durch den Einsatz von Magnetfeldern zur Beeinflussung des Übergangsbereiches zwischen zwei Plasmaelektroden wie auch durch eine geeignet strukturierte Gasversorgung die Uniformität gesteigert werden.

Insbesondere bei einem linearen Array, wie es nach den Ansprüchen 3 bzw. 9 vorgesehen ist, sind entsprechend den Ansprüchen 4 und 10 nur zwei verschiedene phasenverschobene Takte zum interferenzfreien Pulsen aller Plasmaelektroden erforderlich, was den Aufwand für die Steuerung und Mikrowellenerzeugung wirksam begrenzt.

Näher erläutert wird die Erfindung anhand der Zeichnungen.
- Fig 1: zeigt schematisch eine Plasma-CVD-Anlage;
- Fig. 2: zeigt schematisch den zeitlichen Verlauf der Mikrowellenanregung;
- Fig. 3: zeigt schematisch eine Folienbeschichtungsanlage.

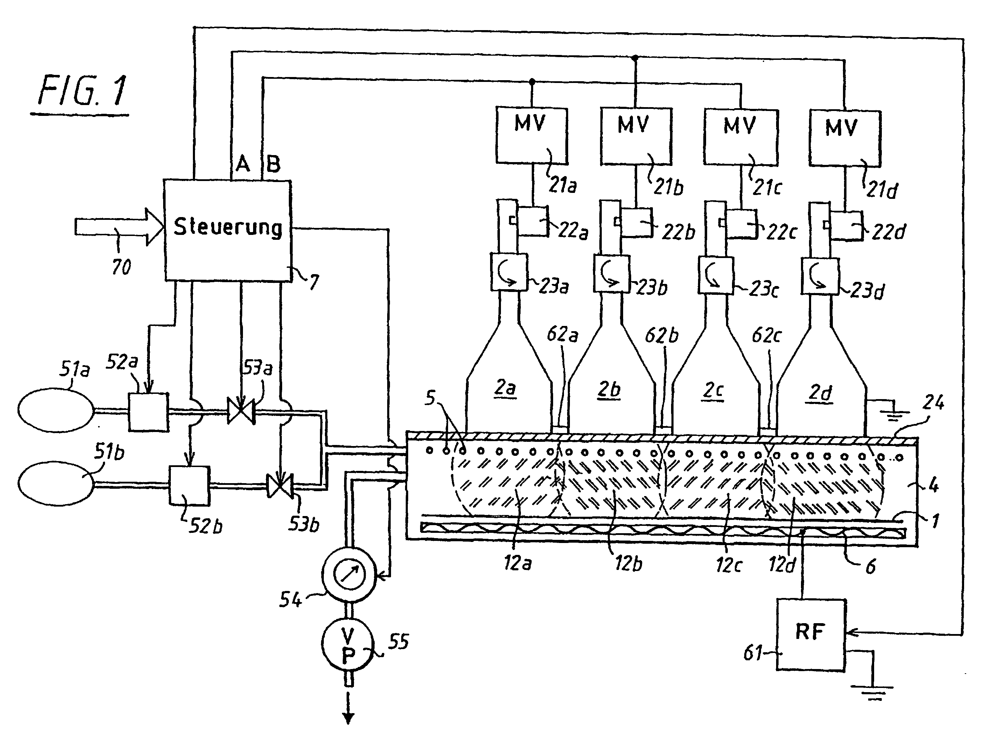

Die in Figur 1 dargestellte Plasma-CVD-Anlage enthält ein Substrat 1, z.B. eine Glasscheibe. Eine Mehrzahl von Mikrowellenantennen, hier vier Stück 2a bis 2d, sind dem Substrat 1 gegenüber in einer Reihe oder auch in einem flächigen Array angeordnet. Diese Horn-Mikrowellenantennen 2a bis 2d dienen als Mikrowellen-Plasmaelektroden und werden von Mikrowellengeneratoren 21a bis 21d über Magnetrons 22a bis 22d und Einwegleitungen 23a bis 23d gespeist. Ein Mikrowellenfenster 24, z.B. gleich wie das Substrat 1 und auch selbst zur Beschichtung bereitstehend, schließt die Vakuumkammer 4 gegen die Mikrowellenantennen 2a bis 2d ab. Das Substrat 1 ist gegenüberliegend parallel in der Vakuumkammer 4 angeordnet.

Das Prozeßgas wird von Gasbehältern 51a, 51b über Massenflußregler 52a, 52b, Gasventile 53a, 53b und die gleichverteilten Gaseinlässe 5 der Vakuumkammer 4 zugeführt und das verbrauchte Restgas wird über einen Druckregler 54 von einer Vakuumpumpe 55 wieder abgesaugt.

Eine Steuerung 7 stellt alle diese Teile entsprechend durch eine Schnittstelle 70 vorgegebener Parameter geeignet ein.

Soweit entspricht die Anlage den bekannten Plasma-CVD-Anlagen, insbesondere auch PICVD-Anlagen und der US 5 017 404 (DE 38 30 249 C2).

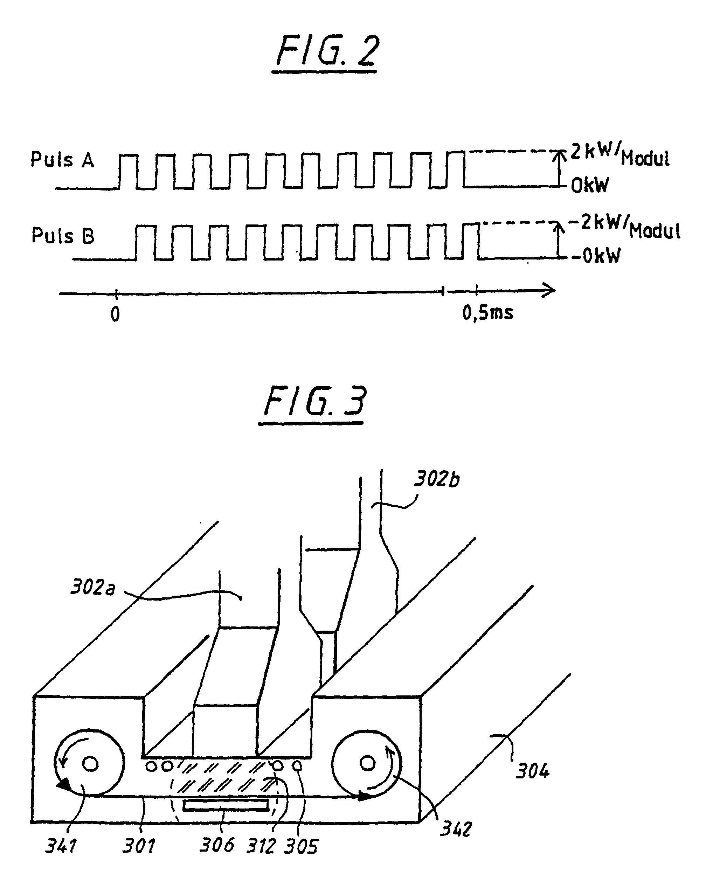

Das Besondere ist, daß die Mikrowellengeneratoren 21a bis 21d in zwei Gruppen 21a, 21c und 21b, 21d getrennt mit Signalen A bzw. B von der Steuerung 7 angesteuert werden, und zwar mit Pulszügen aus kurzen Mikroimpulsen 20A bzw. 20B, welche im Gegentakt phasenverschoben sind. Damit ist von benachbarten Mikrowellenantennen 2a, 2b; 2b, 2c; 2c, 2d zu jeder Zeit nur eine aktiv, so daß Interferenzen ausgeschlossen sind. Figur 2 zeigt diesen Pulsverlauf. Die Pulsdauer und Auszeit der Mikroimpulse liegt jeweils bei 25 Mikrosekunden, ca. 10 Mikroimpulse A und B bilden zusammen einen Puls nach dem PICVD-Verfahren von ca. 0,5 ms Dauer.

Natürlich können die Maßnahmen der US 5 017 404 A zum gezielten Einstellen von Schichtdickenverläufen über das Antennenarray hinweg mit der Erfindung kombiniert werden.

Die entstehenden Plasmazonen 12a bis 12d überlappen sich in ihren Randbereichen mit abnehmender Abscheideleistung ohne Interferenzerscheinungen, so daß ein stabiler gleichmäßiger Übergang allein durch Anpassung der Antennengeometrie an den Übergangsbereichen 62a bis 62d realisiert wird. Die Anpassung der Bereiche 62a bis 62d dient zugleich der optimalen Formung des RF-Felds.

Die Zahl von 4 Mikrowellenantennen 2a bis 2d in einer Reihe ist ein zufällig herausgegriffenes Beispiel. Die typisch einige Zentimeter Breite abdeckenden Module von Mikrowellengenerator 21i, Magnetron 22i, Einwegleiter 23i und Trichterantenne 2i (i von 1 bis n) sind beliebig oft aneinander anreihbar, z.B. auf zwei bis drei Metern Breite zur Belichtung großer Flachglasscheiben oder von Folienbahnen.

Die folgenden Prozeßbeispiele erläutern das Verfahren:

### Prozeßbeispiel 1:

Die Vakuumkammer 4 wird zunächst bis weit unterhalb des gewünschten Prozeßdruckes abgepumpt. Danach wird über die Massenflußregler 52a, 52b sowie die Ventile 53a, 53b eine zum Beschichten geeignete Gasmischung hergestellt. Diese kann z.B. für die Abscheidung von SiO₂ aus 200 sccm (Standardkubikzentimeter) Sauerstoff sowie 20 sccm Hexamethyldisiloxan (HMDSO) bestehen. Während der gesamten Beschichtung fließen diese Gase kontinuierlich (nicht gepulst!). Über die Druckregeleinheit 54 wird ein Prozeßdruck von 1 mbar eingestellt. Sobald dieser erreicht ist, werden die Mikrowellen-Generatoren 21a, 21d mit der in Figur 2 angegebenen Pulsfolge angesteuert.

Jeder Pulszug A, B besteht gemäß Fig. 2 aus 10 Einzelimpulsen ("Mikroimpuls") zu je 25 µs Dauer, die auf Ausgang A und B im Gegentakt phasenversetzt sind. Während der Mikroimpulse, deren Gesamtheit einen PICVD-typischen "Makroimpuls" darstellt, setzt sich das Beschichtungs-Gasgemisch im Plasmaraum 12a bis 12d um und diffundiert zum Substrat 1, auf dem die gewünschte SiO₂-Schicht abgeschieden wird.

Nach Beendigung eines "Makroimpulses" wird das abreagierte Gasgemisch abgesaugt und durch frische Gasmischung ersetzt. Für einen vollständigen Gasaustausch ist die Pulspause zwischen zwei Makroimpulsen typischerweise 10-100ms lang (abhängig von der Geometrie der Vakuumkammer 4). Nach der Pulspause wird wiederum die Mikroimpulsfolge eines Makroimpulses angesteuert, um die nächste Schichtlage abzuscheiden, bis die Soll - Schichtdicke erreicht ist. Danach wird die Vakuumkammer 4 geflutet und das beschichtete Substrat 1 kann entnommen werden.

### Prozeßbeispiel 2:

Der Prozeß mit seinen Parametern verläuft ähnlich wie in Beispiel 1, nur ist diesmal das Substrat eine flexible Folie 301, die kontinuierlich in der Beschichtungskammer 304 bewegt wird. Figur 3 zeigt einen Querschnitt der Anordnung mit Wickeleinrichtung 341, 342 für die Folie 301.

Die Geschwindigkeit der Folie 301 wird so angepaßt, daß jedes Flächenelement der Folie 301 mit der Sollschichtdicke beschichtet wird. Bei typischen Abscheideraten von 500 nm pro Minute und einer Solldicke von 50 nm muß die Folie 301 in sechs Sekunden den Plasmabereich 305 durchqueren. Damit wird auch sichergestellt, daß die Bewegung der Folie 301 während eines Mikroimpulses vernachlässigbar ist.

Der Prozeß verläuft wie in Beispiel 2, wobei während eines Makroimpulses, sowie eine Millisekunde davor und danach, ein RF-Feld angesteuert wird. Durch die geometrische Ausbildung der RF-Elektrode 306, mit verringertem Elektrodenabstand im Bereich der Schnittstelle zweier Mikrowellenantennen 302a, 302b lassen sich die Nicht-Uniformitäten an der Schnittstelle kompensieren. Die Leistung des RF-Generators ist dabei auf optimale Schichtuniformität einzustellen. In einer Durchlaufanlage wird die RF-Leistung über Dickenmessung nach der Beschichtung nachgeregelt.

## Patentansprüche

1. Plasma-CVD-Anlage mit einem Array von Mikrowellen-Plasmaelektroden (2a, b, c, d) und einer Steuerschaltung (7), **dadurch gekennzeichnet, daß** die Steuerschaltung (7) zwei Ausgänge (A, B) aufweist, daß jeweils benachbarte Mikrowellen-Plasmaelektroden (2a, b, c, d) mit verschiedenen Ausgängen (A, B) verbunden sind, daß eine Schaltvorrichtung während des Betriebs der Anlage die zwei Ausgänge (A, B) alternativ zu verschiedenen Zeiten aktiviert, und zwar für jeweils höchstens 50 Mikrosekunden.

2. Plasma-CVD-Anlage nach Anspruch 1, **dadurch gekennzeichnet, daß** zusätzlich ein Radiofrequenz-Anregungssystem (6,61,62a-c) vorgesehen ist.

3. Plasma-CVD-Anlage nach mindestens einem der Ansprüche 1 bis 2, **dadurch gekennzeichnet, daß** ein lineares Array vorgesehen ist.

4. Plasma-CVD-Anlage nach Anspruch 3, **dadurch gekennzeichnet, daß** jede zweite Plasmaelektrode (2a,2c; 2b, 2d) im linearen Array durch die Steuerschaltung (7) zur gleichen Zeit mit Mikrowellenimpulsen (A,B) beaufschlagt wird.

5. Plasma-CVD-Beschichtungsverfahren, bei dem ein Array von Mikrowellen-Plasmaelektroden ein zusammenhängendes Plasma durch pulsförmige Mikrowellenanregung erzeugt, **dadurch gekennzeichnet, daß** je zwei benachbarte Plasmaelektroden zu verschiedenen Zeiten mit Mikrowellenimpulsen beaufschlagt werden, und daß die Dauer der einzelnen Mikrowellenimpulse (A, B) kurz ist gegenüber der Dauer eines Impulses des bekannten Plasma-Impuls-CVD-Verfahrens.

6. Plasma-CVD-Verfahren nach Anspruch 5, **dadurch gekennzeichnet, daß** die Dauer der einzelnen Mikrowellenimpulse höchstens 50 Mikrosekunden beträgt.

7. Plasma-CVD-Verfahren nach Anspruch 5, **dadurch gekennzeichnet, daß** eine Anzahl der Größenordnung 10¹ bis 10² von Mikrowellenimpulsen (A,B) aller Plasmaelektroden (2a-2d) zusammen einen Impuls des Plasma-Impuls-CVD-Verfahrens bildet.

8. Plasma-CVD-Verfahren nach mindestens einem der Ansprüche 5 bis 7, **dadurch gekennzeichnet, daß** zusätzlich durch Radiofrequenz-Anregung ein elektrisches Feld erzeugt wird.

9. Plasma-CVD-Verfahren nach mindestens einem der Ansprüche 5 bis 8, **dadurch gekennzeichnet, daß** ein lineares Array vorgesehen ist und großflächige Substrate (301) streifenweise beschichtet werden.

10. Plasma-CVD-Verfahren nach Anspruch 9, **dadurch gekennzeichnet, daß** nur zwei verschiedene Zeiten (A,B) vorgesehen sind, zu denen Mikrowellenimpulse abgegeben werden, und die Zuordnung zu den Plasmaelektroden (2a-2d) im linearen Array abwechselnd erfolgt.

11. Plasma-CVD-Verfahren nach mindestens einem der Ansprüche 5 bis 10, **dadurch gekennzeichnet, daß** Magnetfelder oder die Gasauslässe (5) zur Uniformisierung der Schichtabscheidung zusätzlich herangezogen werden.

## Claims

1. Plasma CVD system having an array of microwave plasma electrodes (2a, b, c, d) and a control circuit (7), **characterized in that** the control circuit (7) has two outputs (A, B), **in that** respectively adjacent microwave plasma electrodes (2a, b, c, d) are connected to different outputs (A, B), **in that**, while the system is operating, a switching device activates the two outputs (A, B) as alternatives at different times, specifically for in each case at most 50 microseconds.

2. Plasma CVD system according to Claim 1, **characterized in that** a radiofrequency excitation system (6, 61, 62a-c) is additionally provided.

3. Plasma CVD system according to at least one of Claims 1 to 2, **characterized in that** there is a linear array.

4. Plasma CVD system according to Claim 3, **characterized in that** every second plasma electrode (2a, 2c; 2b, 2d) in the linear array is acted on by microwave pulses (A, B) at the same time by the control circuit (7).

5. Plasma CVD coating process, in which an array of microwave plasma electrodes generates a continuous plasma by pulsed microwave excitation, **characterized in that** in each case two adjacent plasma electrodes are acted on by microwave pulses at different times, and **in that** the duration of the individual microwave pulses (A, B) is short compared to the duration of a pulse of the known plasma impulse CVD process.

6. Plasma CVD process according to Claim 5, **characterized in that** the duration of the individual microwave pulses is at most 50 microseconds.

7. Plasma CVD process according to Claim 5, **characterized in that** a number of an order of magnitude of 10¹ to 10² of microwave pulses (A, B) of all the plasma electrodes (2a-2d) together forms a pulse of the plasma impulse CVD process.

8. Plasma CVD process according to at least one of Claims 5 to 7, **characterized in that** an electric field is additionally generated by radiofrequency excitation.

9. Plasma CVD process according to at least one of Claims 5 to 8, **characterized in that** there is a linear array and large-area substrates (301) are coated in strips.

10. Plasma CVD process according to Claim 9, **characterized in that** there are only two different times (A, B) at which microwave pulses are emitted, and the assignment to the plasma electrodes (2a-2d) in the linear array takes place alternately.

11. Plasma CVD process according to at least one of Claims 5 to 10, **characterized in that** magnetic fields or the gas outlets (5) are additionally used to make the layer deposition more uniform.

## Revendications

1. Système de dépôt chimique en phase vapeur par plasma avec une rangée d'électrodes à plasma activées par micro-ondes (2a, b, c, d) et un circuit de commande (7), **caractérisé en ce que** le circuit de commande (7) présente deux sorties (A, B), **en ce que** des électrodes à plasma voisines activées par micro-ondes (2a, b, c, d) sont chaque fois raccordées à des sorties différentes (A, B), **en ce qu'**un dispositif de commande active, pendant le fonctionnement du système, les deux sorties (A, B) alternativement à des instants différents, notamment pour chaque fois au maximum 50 microsecondes.

2. Système de dépôt chimique en phase vapeur par plasma suivant la revendication 1, **caractérisé en ce qu'**il est en outre prévu un système d'excitation par radiofréquence (6, 61, 62a-c).

3. Système de dépôt chimique en phase vapeur par plasma suivant au moins une des revendications 1 à 2, **caractérisé en ce qu'**il est prévu une rangée linéaire.

4. Système de dépôt chimique en phase vapeur par plasma suivant la revendication 3, **caractérisé en ce qu'**une électrode à plasma sur deux (2a, 2c; 2b, 2d) dans la rangée linéaire est activée par le circuit de commande (7) au même instant avec des impulsions de micro-ondes (A, B).

5. Procédé de revêtement chimique en phase vapeur par plasma, dans lequel une rangée d'électrodes à plasma activées par micro-ondes produit un plasma continu par une excitation pulsée à micro-ondes, **caractérisé en ce que** deux électrodes à plasma voisines sont chacune soumises à des impulsions de micro-ondes à des instants différents, et **en ce que** la durée des impulsions de micro-ondes individuelles (A, B) est courte par rapport à la durée d'une impulsion du procédé connu de dépôt chimique en phase vapeur par impulsion de plasma.

6. Procédé de dépôt chimique en phase vapeur par plasma suivant la revendication 5, **caractérisé en ce que** la durée des impulsions de micro-ondes individuelles vaut au maximum 50 microsecondes.

7. Procédé de dépôt chimique en phase vapeur par plasma suivant la revendication 5, **caractérisé en ce qu'**un nombre de l'ordre de grandeur de 10¹ à 10² impulsions de micro-ondes (A, B) de toutes les électrodes à plasma (2a-2d) forme ensemble une impulsion du procédé de dépôt chimique en phase vapeur par impulsion de plasma.

8. Procédé de dépôt chimique en phase vapeur par plasma suivant au moins une des revendications 5 à 7, **caractérisé en ce qu'**un champ électrique est en outre produit par une excitation par radiofréquence.

9. Procédé de dépôt chimique en phase vapeur par plasma suivant au moins une des revendications 5 à 8, **caractérisé en ce qu'**il est prévu une rangée linéaire et que des substrats de grande étendue (301) sont revêtus par bandes.

10. Procédé de dépôt chimique en phase vapeur par plasma suivant la revendication 9, **caractérisé en ce qu'**il n'est prévu que deux instants différents (A, B), auxquels des impulsions de micro-ondes sont émises, et **en ce que** le couplage aux électrodes à plasma (2a-2d) dans la rangée linéaire est effectué en alternance.

11. Procédé de dépôt chimique en phase vapeur par plasma suivant au moins une des revendications 5 à 10, **caractérisé en ce que** l'on fait en outre usage de champs magnétiques ou des sorties de gaz (5) pour l'uniformisation du dépôt en couche.
